# EUROPEAN PATENT APPLICATION

(11) **EP 3 723 288 A1**
(43) Date of publication of application: **14.10.2020**
(21) Application number: 19168956.1
(22) Date of filing: 12.04.2019
(51) Int. Cl.: H03K 17/06, H02M 1/08

(54) **DRIVER CIRCUIT FOR DRIVING A SEMICONDUCTOR SWITCHING ELEMENT, VOLTAGE CONVERTER, ARRANGEMENT WITH AN ELECTRIC MACHINE AND A VOLTAGE CONVERTER AND VEHICLE**

(71) Applicant: Valeo Siemens eAutomotive Germany GmbH, 91056 Erlangen (DE)
(72) Inventor: Lempidis, Georgios, 91058 Erlangen (DE)
(74) Representative: Dr. Gassner & Partner mbB

(57) **Abstract**

Driver circuit (1) for driving a semiconductor switching element (3), comprising
- a power input (10) for an operating voltage (11),
- a driver unit (12) having a first supply terminal (13) and a second supply terminal (14),
- a bootstrap unit (18) with an input terminal (19) being connected to the power input (10) and with an output terminal (20) being connected to the first supply terminal (13) of the driver unit (12) and
- an inverting DC/DC converter unit (21) having an input terminal (22) connected to the output terminal (20) of the bootstrap unit (18) and an output terminal (23) connected to the second supply terminal (14) of the driver unit (18).

## Description

The present invention refers to a driver circuit for driving a semiconductor switching element, comprising a power input for an operating voltage, a driver unit having a first supply terminal and a second supply terminal and a bootstrap unit with an input terminal being connected to the power input and with an output terminal being connected to the first supply terminal of the driver unit.

Besides, the present invention refers to a power converter, an arrangement and a vehicle.

For driving a semiconductor switching element that is on a floating potential, e.g. due to being arranged at a high side of a half bridge of a power converter, a supply voltage provided to supply terminals of a driver unit has to be adapted to the floating potential. As a cheap and simple way to provide such a floating potential driver circuits with a bootstrap unit are known, which are appreciated for having low parasitic capacitances.

The document US 5 969 964 A discloses a power circuit, comprising: a high side MOS gated transistor, a low side MOS gated transistor coupled in series with the high side MOS gated transistor operable to form a bridge circuit across high and low power terminals of a power source, a high side driver circuit having an output operable to change conduction characteristics of the high side MOS gated transistor and a series coupled diode and capacitor configured in a bootstrap arrangement with the high side and low side transistors to provide an operating voltage to the high side driver circuit.

Such a conventional driver circuit uses a potential at a source or emitter terminal of the semiconductor switching element as low supply potential and a corresponding higher potential realized by the operating voltage and the bootstrap unit as high supply potential. Thus, a potential at an output of the driver unit cannot be lower than the potential at the source or emitter terminal. However, there are semiconductor switching elements that require a negative voltage between their gate and their source or emitter terminal for switching off. Typically, for those semiconductor switching elements expensive additional isolated power supplies are used instead of bootstrap units.

Therefore, it is an object of the present invention to drive a broad range of semiconductor switching elements by means of a bootstrap unit.

According to the present invention the above object is solved by a driver circuit as initially described further comprising an inverting DC/DC converter unit having an input terminal connected to the output terminal of the bootstrap unit and an output terminal connected to the second supply terminal of the driver unit.

The invention aims to convert a voltage at the output terminal of the bootstrap unit into an inverted voltage for the second supply terminal of the driver unit. This allows to drive the semiconductor switching element not only with a voltage at the output terminal of the bootstrap unit in a first switching state but additionally with an inverted voltage provided by the inverting DC/DC converter unit in a second switching state of the semiconductor switching element. Advantageously, by means of an inverted voltage the driver circuit according to the invention is capable of driving a semiconductor switching element that requires a negative control voltage, which makes the driver circuit usable for a broader range of semiconductor switching elements.

Preferably, the DC/DC converter is inductorless. Thereby, large inductor elements for providing the inverted voltage can be omitted. It is, however, possible to realize the DC/DC converter unit by a topology having an inductor, alternatively. Such a topology may be a buck-boost-converter.

Advantageously, the DC/DC converter unit is realized by a charge pump. The charge pump typically comprises a capacitive storage element for voltage conversion. Thus, a charge pump can be realized with low component effort and low mounting space.

Typically, the driver circuit according to the invention comprises a reference input for a reference potential of a terminal of the semiconductor switching element. The terminal is typically a source or emitter terminal of the semiconductor switching element. Therein, the DC/DC converter unit may comprise a reference terminal being connected to the reference input. Advantageously, the reference potential is fed directly to the DC/DC converter unit.

It is highly preferred that the DC/DC converter unit is configured to convert a positive voltage between the input terminal and the reference terminal into a negative voltage between the output terminal and the reference terminal.

Alternatively or additionally, the DC/DC converter unit comprises an energy storage subunit and a switching subunit being configured to alternatingly connect the energy storage subunit to the reference terminal and to the input terminal. Typically, the switching frequency of the switching subunit is higher than the frequency of control signals provided to the driver unit.

Preferably, the DC/DC converter unit is configured to provide a voltage between the output terminal and the reference terminal having an absolute value of at least 2 V, preferably at least 4 V, more preferably at least 6 V, and/or at most 14 V, preferably at most 12 V, more preferably at most 10 V
in a stationary state of the bootstrap unit. Thereby, suitable control voltages, particularly gate-emitter-voltages, for an insulated gate bipolar transistor (IGBT) can be provided by the driver circuit. The term "stationary state of the bootstrap unit" refers to an operating state, in which an energy storage of the bootstrap unit is charged so as to hold a substantially constant voltage difference between the power input of the driver unit and the reference potential.

Furthermore, the DC/DC converter unit may comprise a voltage limitation subunit configured to limit the voltage between the output terminal and the reference terminal to a predetermined value. Thereby, an overvoltage at the supply terminals that may exceed maximum rated voltages of the semiconductor switching element can be avoided. The voltage limitation subunit may comprise a Zener diode.

Preferably, the bootstrap unit comprises a diode subunit, a capacitor subunit and a reference terminal being connected to the reference input, wherein a first terminal of the diode subunit is connected to the power input, a second terminal of the diode subunit is connected to a first terminal of the capacitor subunit and to the output terminal and a second terminal of the capacitor subunit is connected to the reference terminal of the bootstrap unit. Typically, with respect to the diode subunit the first terminal is an anode and the second terminal is a cathode.

Furthermore, the driver unit may comprise a reference terminal being connected to the reference input.

Besides, the present invention refers to a power converter, comprising a DC link having a first line for a first DC potential and a second line for a second DC potential, one or multiple half bridges formed by a first semiconductor switching element connected to the first line and by a second semiconductor switching element connected to the second line and a driver circuit according to the invention for each half bridge, the driver circuit being configured to drive a control terminal of the first semiconductor switching element. Typically, the semiconductor switching elements are insulated gate bipolar transistors, particularly being configured to be switched by a negative gate-emitter-voltage.

Therein, it is preferred that the reference input of a respective driver circuit is connected to a tap between the first semiconductor switching element and the second semiconductor switching element of the half bridge.

Preferably, the power converter according to the invention is configured to convert a voltage obtained at the DC link into a multiphase AC current, wherein the half bridge and the driver circuit is provided for each phase of the AC current. Thus, the power converter may be considered as inverter.

Besides, the present invention refers to an arrangement with an electric machine and a power converter according to the invention, wherein the power converter is configured to provide an AC current to stator winding of the electric machine.

Finally, the present invention refers to a vehicle comprising an arrangement according to the invention configured to drive the vehicle. Thus, the vehicle may be considered as an electric vehicle, particularly a battery electric vehicle or a hybrid electric vehicle.

All statements referring to the driver circuit according to the invention apply analogously to the power converter according to the invention, to the arrangement according to the invention and to the vehicle according to the invention so that the aforementioned advantages may be achieved by them as well.

Further details and advantages are disclosed in the following, wherein reference is made to the schematic drawings showing:
- Fig. 1: a circuit diagram of an embodiment of a driver circuit according to the invention;
- Fig. 2: a diagram of electric quantities over time during operation of the driver circuit shown in Fig. 1;
- Fig. 3: a block diagram of an embodiment of an arrangement according to the invention with an embodiment of a power converter according to the invention; and
- Fig. 4: a block diagram of an embodiment of a vehicle according to the invention.

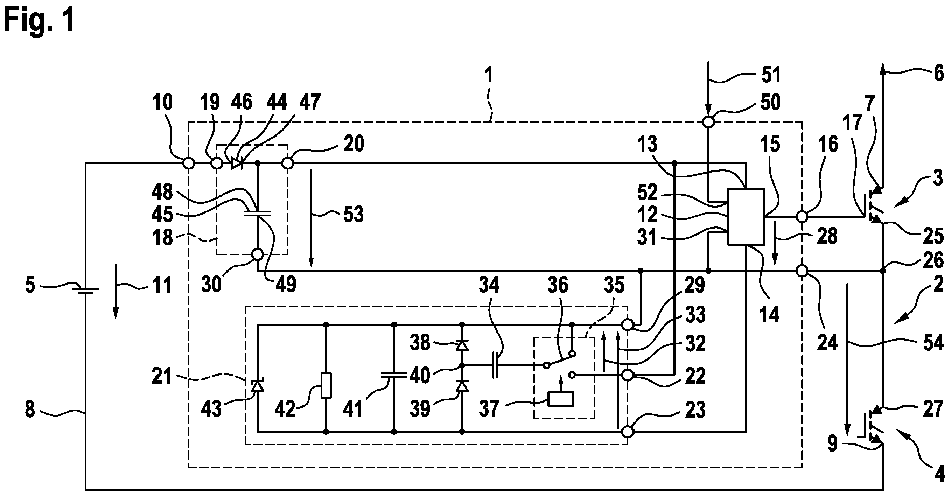

- Fig. 1: is a circuit diagram of an embodiment of a driver circuit 1.

As external elements with respect to the driver circuit 1 a half bridge 2 comprising a first semiconductor switching element 3 on a high side, a second semiconductor switching element 4 on a low side and an operating voltage source 5 are depicted. The semiconductor switching elements 3, 4 are realized by insulated gate bipolar transistors (IGBT). Therein, a positive high-voltage 6 is connected to a first terminal 7 realized by a collector of the first semiconductor switching element 3 and a negative high-voltage 8 is connected to a second terminal 9 realized by an emitter of the second semiconductor switching element 4 as well as to a negative potential of the operating voltage source 5.

The driver circuit 1 comprises a power input 10 for an operating voltage 11 provided by the operating voltage source 5 and a driver unit 12 having a first supply terminal 13, a second supply terminal 14 and an output terminal 15 forming an output 16 of the driver circuit 1. Within the configuration shown in Fig. 1 a control terminal 17 realized by a gate of the first semiconductor switching element 3 is connected to the output 16. Furthermore, the driver circuit 1 comprises a bootstrap unit 18 with an input terminal 19 being connected to the power input 10 and with an output terminal 20 being connected to the first supply terminal 13 of the driver unit 12.

Additionally, the driver circuit 1 comprises an inverting DC/DC converter unit 21 having an input terminal 22 connected to the output terminal 20 of the bootstrap unit 18 and an output terminal 23 connected to the second supply terminal 14 of the driver unit 14. The DC/DC converter unit 21 is inductorless and realized by a charge pump.

The driver circuit 1 further comprises a reference input 24 for a reference potential of a second terminal 25 realized by an emitter of the first semiconductor switching element 3. The reference terminal 24 is connected to a tap 26 between the second terminal 25 of the first semiconductor switching element 3 and a first terminal 27 realized by a collector of the second semiconductor switching element 4. Thus, a control voltage 28 between the control terminal 17 and the second terminal 25 of the first semiconductor switching element 3 or between the output 16 and the reference input 24 of the driver circuit 1, respectively, is provided. The reference terminal 24 is connected to a reference terminal 29 of the DC/DC converter 21, to a reference terminal 30 of the bootstrap unit 18 and to a reference terminal 31 of the driver unit 12, i.e. the aforementioned reference terminals 29, 30, 31 and the reference input 24 are on the same potential.

The DC/DC converter unit 21 is configured to convert a positive voltage 32 between the input terminals 22 and the reference terminal 29 into a negative voltage 33 between the output terminal 23 and the reference terminal 29. Thereto, the DC/DC converter unit 21 comprises an energy storage subunit 34 formed by a capacitor and a switching subunit 35 being configured to connect the energy storage subunit 34 to the reference terminal 29 and to the input terminal 22 alternatingly. The switching subunit 35 comprises a switch section 36 and a clock section 37 configured to provide a switching pattern for the switch section 36 such that the voltage 32 is converted into the desired value of the voltage 33.

Furthermore, the DC/DC converter section 21 comprises a first diode subunit 38, whose anode is connected to a terminal of the energy storage subunit 34 that is not connected to the switching subunit 25 and whose cathode is connected to the reference terminal 29. Besides, a second diode subunit 39, whose cathode is connected to the terminal of the energy storage subunit 34 that is not connected to the switching subunit 35 and whose anode is connected to the output terminal 23 is provided. Consequently, the anode of the first diode 38 subunit, the cathode of the second diode subunit 39 and the terminal of the energy storage subunit 34 that is not connected to the switching subunit 25 are on the same potential 40. Additionally, the DC/DC converter unit 21 comprises an output capacitor subunit 41 and an output resistor subunit 42 connected in parallel between the output terminal 23 and the reference terminal 29.

The DC/DC converter unit 21 is configured to provide the negative output voltage 33 with an absolute value of approximately 8.2 V in a stationary state of the bootstrap unit 18. For limiting the output voltage 33 to this value the DC/DC converter subunit 21 comprises a voltage limitation subunit 43 realized by a Zener diode.

The bootstrap unit 18 comprises a diode subunit 44 and a capacitor subunit 45. A first terminal 46 being the anode of the diode subunit 44 forms the input terminal 19 and is connected to the power input 10. A second terminal 47 of the diode subunit 44 being its cathode is connected to a first terminal 48 of the capacitor subunit 45 and to the output terminal 20. The second terminal 49 of the capacitor subunit 45 is connected to the reference terminal 30.

Finally, the driver circuit 1 comprises a control input 50 configured to obtain a control signal 51 according to which the first semiconductor switching element 3 performs switching on and off. Thereto, a control terminal 52 of the driver unit 12 is connected to the control input 50 and the driver unit 12 is configured to provide the control voltage 28 at its output terminal 15 based on one of the voltages at the supply terminals 13, 14 depending on a signal state of the control signal 51. Note that a series resistor for the control terminal 17 may be integrated into the driver unit 12.

As can be seen from Fig. 1 the second terminal 25 of the first semiconductor switching element 3 and the reference input 24 of the driver circuit 1 have a floating potential depending on the switching state of the second semiconductor switching element 4. By providing the bootstrap unit 18 an output voltage 53 between the output terminal 20 and the reference terminal 30 or the reference input 24, respectively, is kept on a substantially constant level, when the capacitor subunit 45 of the bootstrap unit 18 is charged. Therein, the diode subunit 44 allows to charge the capacitor subunit 45 when the potential at the reference input 24 is low. By using the DC/DC converter subunit 21 it is possible to provide the negative voltage 33 to the second supply terminal 14 of the driver unit 12 for allowing the semiconductor switching element 3 to be driven with the negative voltage 33 for being switched off.

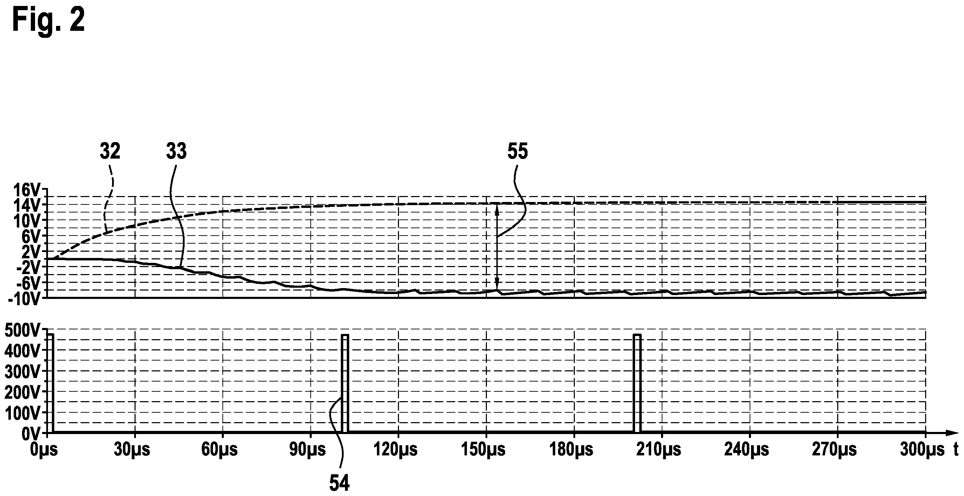

Fig. 2 is a diagram of electric quantities over time t during operation of the driver circuit 1 shown in Fig. 1. Therein, an upper diagram depicts a progress of the voltage 32 and of the voltage 33. In a lower diagram a voltage 54 across the second semiconductor switching element 4 or between the reference input 24 and the negative high-voltage 8, respectively, is depicted. As can be seen, the voltage 54 is a pulse-width-modulated voltage with a period time of 100 µs and a pulse width of 2 µs, exemplarily.

At a time denoted with 0 µs the capacitor subunit 45 and all other energy storages of the driver circuit 1 are discharged. After the end of the first pulse at 2 µs the voltage 53 rises due to the diode subunit 44 being conductive and the capacitor subunit 45 being charged by the operating voltage source 5. With a short delay the DC/DC converter unit 21 charges the energy storage subunit 34 and realizes the negative voltage 33 which reaches a value of about -8 V after approximately 100 µs, therein providing a stable voltage difference 55 after approximately 150 µs for reliably switching the semiconductor switching element 3 with a positive and a negative voltage. In Fig. 2 the switching operation of the switching subunit 35 can be recognized by ripples in progress of the voltage 33.

According to a further embodiment the DC/DC converter unit 21 has an inductor as energy storage and is realized by a buck-boost converter.

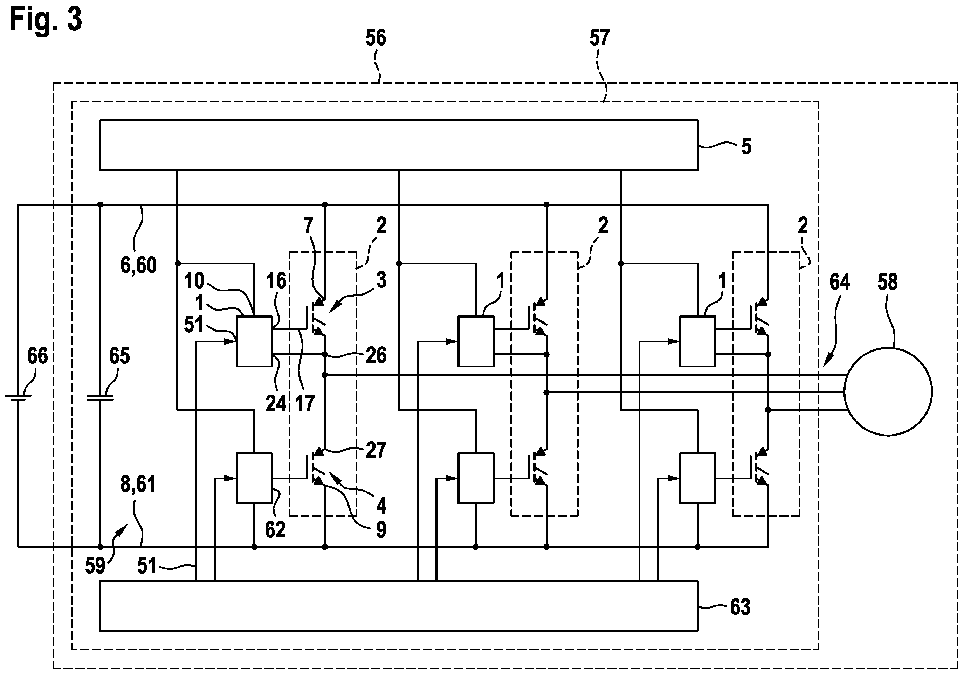

Fig. 3 is a block diagram of an embodiment of an arrangement 56 with a power converter 57 and with an electric machine 58. Therein, equal or equivalent components are denoted with identic reference signs with respect to the aforementioned embodiments.

The power converter 57 comprises a DC link 59 having a first line 60 for a first DC potential corresponding to the positive high-voltage 6 and a second line 61 for a second DC potential corresponding to the negative high-voltage 8. Between the DC potential lines 60, 61 three half bridges 2 formed by a first semiconductor switching element 3 connected to the first line 60 and by a second semiconductor switching element 4 connected to the second line 61 are connected. For each half bridge 2 a driver circuit 1 according to any of the aforementioned embodiments for driving a control terminal 17 of the first semiconductor switching element 3 is provided. Thereto, the output 16 of the driver circuit 1 is connected to the control terminal 17 and the reference input 24 of each driver circuit 1 is connected to the tap 26 between the first semiconductor switching element 3 and the second semiconductor switching element 4 of the half bridge 2.

The second semiconductor switching element 4 of each half bridge 2 is driven by a further driver circuit 62 that corresponds substantially to the driver unit 12 of the driver circuit 1. As the potential of the second terminal 9 of the second semiconductor switching element 4 is not floating a bootstrap unit and the DC/DC converter unit are not required for the driver circuit 62.

The power converter 57 further comprises an operational power source 5 which provides the operating voltage 11 for each driver circuit 1, 62. Besides, the power converter 57 comprises a control unit 63 configured to provide the control signal 51 to the control input 50 of each driver circuit 1 and to corresponding control inputs of the driver circuits 62.

The control unit 63 is configured to provide the control signals 51 such that the electric machine 58 is supplied with a three-phase AC output current at an output 64 of the power converter 57. The DC link 59 is formed by a DC link capacitor 65 which is connected in parallel to a high-voltage battery 66 supplying the arrangement 56.

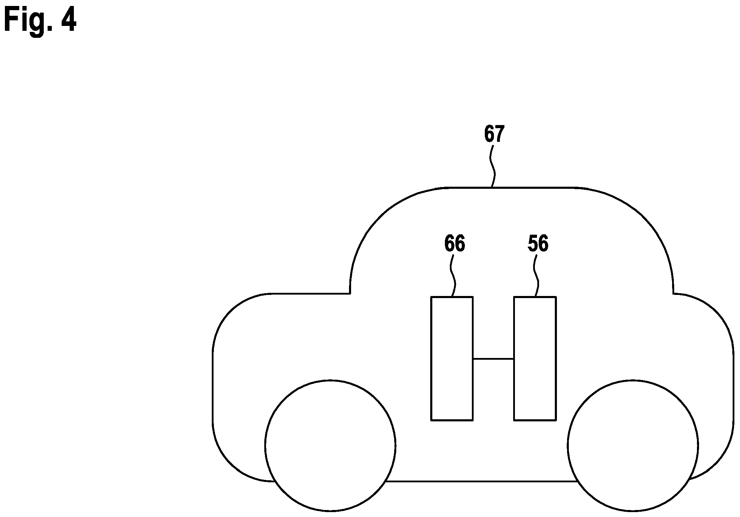

Fig. 4 is a block diagram of an embodiment of a vehicle 67 comprising an arrangement 56 according the above embodiment configured to drive the vehicle 67 and a high-voltage battery 66.

## Claims

1. Driver circuit (1) for driving a semiconductor switching element (3), comprising
- a power input (10) for an operating voltage (11),
- a driver unit (12) having a first supply terminal (13) and a second supply terminal (14) and
- a bootstrap unit (18) with an input terminal (19) being connected to the power input (10) and with an output terminal (20) being connected to the first supply terminal (13) of the driver unit (12),
**characterized by**
an inverting DC/DC converter unit (21) having an input terminal (22) connected to the output terminal (20) of the bootstrap unit (18) and an output terminal (23) connected to the second supply terminal (14) of the driver unit (18).

2. Driver circuit according to claim 1, wherein the DC/DC converter unit (21) is inductorless.

3. Driver circuit according to claim 1 or 2, wherein the DC/DC converter (21) unit is realized by a charge pump.

4. Driver circuit according to any of the preceding claims, comprising a reference input (24) for a reference potential of a terminal (25) of the semiconductor switching element (3).

5. Driver circuit according to claim 4, wherein the DC/DC converter unit (21) comprises a reference terminal (29) being connected to the reference input (24).

6. Driver circuit according to claim 5, wherein the DC/DC converter unit (21) is configured to convert a positive voltage (32) between the input terminal (22) and the reference terminal (29) into a negative voltage (33) between the output terminal (23) and the reference terminal (29).

7. Driver circuit according to claim 5 or 6, wherein the DC/DC converter unit (21) comprises an energy storage subunit (34) and a switching subunit (35) being configured to alternatingly connect the energy storage subunit (34) to the reference terminal (29) and to the input terminal (22).

8. Driver circuit according to claim 6 or 7, wherein the DC/DC converter unit (21) is configured to provide the voltage (33) between the output terminal (23) and the reference terminal (29) having an absolute value of
- at least 2 V, preferably at least 4 V, more preferably at least 6 V, and/or
- at most 14 V, preferably at most 12 V, more preferably at most 10 V in a stationary state of the bootstrap unit (18).

9. Driver circuit according to any of claim 6 to 8, wherein the DC/DC converter (21) unit comprises a voltage limitation subunit (43) configured to limit the voltage (33) between the output terminal (23) and the reference terminal (29) to a predetermined value.

10. Driver circuit according to any of claims 4 to 8, wherein the bootstrap unit (18) comprises a diode subunit (44), a capacitor subunit (45) and a reference terminal (30) being connected to the reference input (24), wherein a first terminal (46) of the diode subunit (44) is connected to the power input (10), a second terminal (47) of the diode subunit (10) is connected to a first terminal (48) of the capacitor subunit (45) and to the output terminal (20) and a second terminal (49) of the capacitor subunit (45) is connected to the reference terminal (30) of the bootstrap unit (18).

11. Power converter (57), comprising
- a DC link (59) having a first line (60) for a first DC potential and a second line (61) for a second DC potential,
- one or multiple half bridges (2) formed by a first semiconductor switching element (3) connected to the first line (60) and by a second semiconductor switching element (4) connected to the second line (61) and
- a driver circuit (1) according to any of the preceding claims for each half bridge (2), the driver circuit (1) being configured to drive a control terminal (17) of the first semiconductor switching element (3).

12. Power converter according to claim 11, when depending on claim 4, wherein the reference input (24) of a respective driver circuit (1) is connected to a tap (26) between the first semiconductor switching element (3) and the second semiconductor switching element (4) of the half bridge (2).

13. Power converter according to claim 11 or 12, which is configured to convert a voltage obtained at the DC link (59) into a multiphase AC current, wherein a half bridge (2) and a driver circuit (1) is provided for each phase of the AC current.

14. Arrangement (56) with an electric machine (58) and a power converter (57) according to any of claims 11 to 13, wherein the power converter (57) is configured to provide an AC current to stator windings of the electric machine (58).

15. Vehicle (67), comprising an arrangement (56) according to claim 14 configured to drive the vehicle (67).
